# EUROPÄISCHE PATENTSCHRIFT

(11) **EP 2 805 590 B1**
(45) Veröffentlichungstag und Bekanntmachung des Hinweises auf die Patenterteilung: **24.11.2021**
(21) Anmeldenummer: 12815632.0
(22) Anmeldetag: 04.12.2012
(51) Int. Cl.: H05K 7/20

(54) **KÜHLANORDNUNG FÜR EIN WÄRME ERZEUGENDES BAUELEMENT, SCHAUMSTOFF UND VERWENDUNG EINES SCHAUMSTOFFES FÜR EINE KÜHLANORDNUNG**
COOLING ARRANGEMENT FOR A HEAT-GENERATING COMPONENT, FOAM AND USE OF A FOAM FOR A COOLING ARRANGEMENT
AGENCEMENT DE REFROIDISSEMENT POUR UN COMPOSANT PRODUISANT DE LA CHALEUR, MOUSSE ET UTILISATION D'UNE MOUSSE POUR UN AGENCEMENT DE REFROIDISSEMENT

(30) Priorität: 17.01.2012 DE 102012000678
(43) Veröffentlichungstag der Anmeldung: 26.11.2014
(73) Patentinhaber: SEW-EURODRIVE GmbH & Co. KG, 76646 Bruchsal (DE)
(72) Erfinder: SCHMIDT, Josef, 76676 Graben-Neudorf (DE); NIKOLA, Joachim, 76703 Kraichtal (DE); SCHÖRNER, Martin, 76646 Bruchsal (DE)
(86) Internationale Anmeldenummer: PCT/EP2012/004989
(87) Internationale Veröffentlichungsnummer: WO 2013/107478

(56) Entgegenhaltungen:
- EP-A2- 2 040 526
- WO-A1-99/59225
- WO-A1-2010/129647
- DE-A1-102010 050 120
- A K NANDI ET AL: "Studies on effective thermal conductivity of particle-reinforced polymeric flexible mould material composites", JOURNAL OF MATERIALS: DESIGN AND APPLICATIONS - PART L, vol. 225, no. 3, 13 July 2011 (2011-07-13) , pages 149-159, XP055494105, GB ISSN: 1464-4207, DOI: 10.1177/0954420711403568
- Polartherm(TM): "Heat Advanced Ceramics | Polartherm Boron Nitride Fillers", , 31 December 2001 (2001-12-31), pages 1-4, XP055494125, Ohio, Cleveland, USA Retrieved from the Internet: URL:http://jsdhp1.kek.jp/~unno/SCTSGmod/gl ue/BN-PT140S.pdf [retrieved on 2018-07-20]

## Beschreibung

Die Erfindung betrifft eine Kühlanordnung für ein Wärme erzeugendes Bauelement.

Als Schaumstoff ist beispielsweise Styropor bekannt, der durch Schäumen eines Materials, das ein Kunststoff, wie Polypropylen, ist, herstellbar ist. Dabei ist allgemein bekannt, dass solche Schaumstoffe als Wärmesperre weitverbreitete Verwendung finden.

Aus der WO 99/59225 A1 ist ein Schaumstoffgehäuse für eine Leiterplatte bekannt. Aus der DE 10 2010 050 120 A1 ist ein Verfahren zum Herstellen eines plastisch verformten Kunststoffkörpers, Anordnung und Elektrogerät bekannt.

Aus der EP 2 040 526 A2 ist ein elektrisches Gerät, insbesondere Steuergerät für ein Kraftfahrzeug bekannt.

Aus der WO 2010 / 129647 A1 ist als nächstliegender Stand der Technik ein wärmeleitendes Schaumprodukt aus elektrisch isolierendem Material bekannt, das als Zwischenteil zwischen einer elektronischen Schaltung und einem Kühlkörper vorgesehen ist.

Aus dem Artikel von A.K. Nandi, K.Deb, S. Datta und J. Orkas, "Studies on effective thermal conductivity of particle-reinforced polymeric flexible mould material composite", Proc. IMechE Vol. 225, Part L: Journal of Materials: Design and Applications, Nr. 3, (2011), S. 149-159 sind wärmeleitfähige Polymerschäume bekannt.

Aus dem Datenblatt von Polarterm™ "Heat Advanced Ceramics | Polartherm Boron Nitride Fillers" von Advanced Ceramics, (URL: http://jsdhp1.kek.jp/~unno/ SCTSGmod/glue/BN-PT140S.pdf), (2001), Ohio, Cleveland, USA, sind wärmeleitende Füllmaterialien bekannt.

Der Erfindung liegt daher die Aufgabe zugrunde, die Entwärmung bei Elektrogeräten kostengünstig zu verbessern.

Erfindungsgemäß wird die Aufgabe bei der Kühlanordnung nach den in Anspruch 1 angegebenen Merkmalen gelöst.

Wichtige Merkmale der Erfindung bei der Kühlanordnung für ein Wärme erzeugendes Bauelement sind, dass die Kühlanordnung
- eine Wärmequelle, ein Wärme erzeugendes Bauelement,
- eine Wärmesenke, welche als ein metallischer Kühlkörper ausgeführt ist,
- und ein zwischen Wärmequelle und Wärmesenke angeordnetes Zwischenteil umfasst,
   wobei das Zwischenteil aus wärmeleitendem Schaumstoff gefertigt ist,
   wobei der Schaumstoff Gaseinschlüsse und/oder Gas-befüllte Ausnehmungen aufweist, welche jeweils zumindest teilweise oder ganz von einem Material umgeben sind.
   Von Vorteil ist dabei, dass somit ein Schaumstoff als Wärmeableitung verwendet wird. Dies funktioniert trotz der Wärme isolierenden Gaseinschlüsse oder Gas-befüllten Ausnehmungen mittels des Materials - trotz der durch Zusätze vermindernden Schäumfähigkeit des Materials . Denn die notwendigen Zusätze zur Erhöhung der Wärmeleitfähigkeit gefährden die Schäumfähigkeit und erfordern auf jeden Fall höhere Energiemengen bei der Fertigung, da die Wärme schneller abgeleitet wird, wenn das Material wärmeleitfähiger ist.

Bei Verwendung entsprechend harten, also steifen, Materials ist auch eine Gehäusefunktion durch den Schaumstoff realisierbar. Auf diese Weise weist das somit mit der Kühlanordnung gebildete Elektrogerät eine geringe Dichte auf. Der Schaumstoff schützt außerdem die umgebene Leiterplatte durch sein großes Absorptionsvermögen für Stoßenergieen. Beispielsweise wird bei einem Aufprall gegen eine Wand, beispielsweise beim Herunterfallen der Kühlanordnung auf den Boden, sehr viel Energie durch Verformung, insbesondere auch plastische inelastische Verformung, des Schaumstoffes absorbiert im Schaumstoff und somit die Leiterplatte geschützt.

Erfindungsgemäß verbindet das Zwischenteil die Wärmequelle mit der Wärmesenke. Von Vorteil ist dabei, dass eine direkte Einleitung der Wärme des Wärme erzeugenden Bauelements oder des Raumbereichs, in welchem das Wärme erzeugende Bauelement angeordnet ist, ermöglicht ist. Die direkte Einleitung von der Wärmequelle und die Ausleitung an die Wärmesenke, also beispielsweise Umgebungsluft oder eine Montageplatte, auf der das Elektrogerät montiert ist, ermöglicht eine effektive Entwärmung über diesen Wärmeleitpfad, der den geringsten Wärmeleitwiderstand aufweist.

Erfindungsgemäß ist die Wärmequelle ein Wärme erzeugendes Bauelement, welches auf einer Leiterplatte bestückt ist,
wobei das Zwischenteil die bestückte Leiterplatte beidseitig umgibt. Von Vorteil ist dabei, dass das Zwischenteil gehäusebildende Funktion ausführbar macht.

Bei einer vorteilhaften Ausgestaltung ist das Gas Luft oder Kohlendioxid. Von Vorteil ist dabei, dass ein geringes spezifisches Gewicht des Schaumstoffs erreichbar ist bei gleichzeitig hoher Steifigkeit und mechanischer Belastbarkeit.

Erfindungsgemäß ist das Material ein Kunststoff, insbesondere Polypropylen, wobei dem Kunststoff Bornitrid, insbesondere Bornitrid-Pulver, beigefügt ist,

Erfindungsgemäß beträgt der Volumenanteil des Bornitrid im Material zwischen 3 % und 30 %, insbesondere vorzugsweise 5 bis 15 %. Von Vorteil ist dabei, dass ein mechanisch sehr harter und somit belastbarer Stoff die mechanische Belastbarkeit des Schaumstoffes verbessert und außerdem die Wärmeleitfähigkeit durch Bildung von innerhalb des Materials angeordneten Wärmeleitpfaden mit geringem Wärmeleitwiderstand verbessert. Dabei weisen die Wärmeleitpfade, aneinander angereihte Partikel aus Bornitrid auf, so dass entlang dieser so gebildeten Reihen von sich berührenden Partikeln eine effektive Wärmeleitung stattfindet. Auch wenn die Ketten an manchen Stellen unterbrochen sein sollten, ist der Wärmeleitwiderstand entlang dieser unterbrochenen Ketten geringer als auf einem Pfad, welcher durch das restliche Material ohne Bornitrid und/oder durch Gaseinschlüsse verläuft.

Erfindungsgemäß ist der Wärmeleitwiderstand von der Wärmequelle zur Wärmesenke über den Schaumstoff geringer als der Wärmeleitwiderstand über jeden anderen Wärmeleitpfad, der nicht den Schaumstoff durchläuft, von der Wärmequelle zur Wärmesenke. Von Vorteil ist dabei, dass die Wärme im Wesentlichen über den Schaumstoff zur Wärmesenke transportiert wird, insbesondere entlang der im Material gebildeten Bornitrid-Ketten.

Bei einer vorteilhaften Ausgestaltung ist dem Material ein Farbstoff beigemischt. Von Vorteil ist dabei, dass der Schaumstoff beispielsweise in der Firmenfarbe kennzeichenbar ist.

Erfindungsgemäß weist das Bornitrid eine durchschnittliche Korngröße zwischen 0,5 µm und 50 µm, insbesondere zwischen 1µm und 10µm, auf. Von Vorteil ist dabei, dass die Ketten der Bornitrid-Partikel innerhalb des Materials gebildet werden können, ohne dass die Zellwände, welche die Gaseinschlüsse zumindest teilweise umgeben, zerstört werden und somit die Schäumfähigkeit kritisch beeinträchtigen werden könnte.

Erfindungsgemäß umgibt der Schaumstoff die mit den Wärme erzeugenden Bauelementen bestückte Leiterplatte gehäusebildend. Von Vorteil ist dabei, dass der Schaumstoff auch eine Gehäusefunktion übernimmt. Somit ist ein weiteres Schutzgehäuse verzichtbar.

Erfindungsgemäß ist der Schaumstoff elektrisch isolierend, insbesondere wobei die Isolationsfestigkeit des Schaumstoffes gleich ist wie bei trockener Luft unter Normaldruck bei 20°Celsius oder höher. Von Vorteil ist dabei, dass der Schaumstoff direkt auf die elektrischen Bauelemente und die Leiterplatte anordenbar ist. Somit ist eine direkte Wärmeeinleitung, also ein berührender Wärmekontakt ermöglicht. Vorzugsweise wird der Schaumstoff im Bereich des Wärmekontaktes erhitzt, bevor er mit den Wärme erzeugenden Bauelementen verbunden wird. Hierbei ist eine derartige Temperatur wählbar, dass der Schaumstoff im Kontaktbereich etwas verflüssigt wird und somit eine stoffschlüssige Verbindung zum Wärme erzeugenden Bauelement entsteht. Der Kontaktbereich ist auf diese Weise ohne Gaseinschlüsse ausgeführt, so dass eine große Menge Bornitrid im Kontaktbereich sich befindet.

Die Wärmesenke ist zumindest teilweise auch als Kühlkörper ausführbar, so dass der Schaumstoff zwischen dem Kühlkörper und dem Wärme erzeugenden Bauelement anordenbar ist.

Wichtige Merkmale bei dem Schaumstoff sind, dass er für eine vorgenannte Kühlanordnung verwendet wird.

Von Vorteil ist dabei, dass eine Schaumstoff nicht zur Wärmeisolation sondern zur Wärmeableitung und zur Gehäusebildung für eine mit Wärme erzeugenden Bauelementen bestückte Leiterplatte verwendet wird. Somit ist ein Stoff mit einem niedrigen spezifischen Gewicht verwendbar.

Wichtige Merkmale bei der Verwendung eines Schaumstoffs als Wärmeableitung in einer vorgenannten Kühlanordnung sind, dass er nicht zur Wärmeisolation oder als Wärmesperre verwendet wird, sondern als Wärmeleiter.

Von Vorteil ist dabei, dass der Schaumstoff ein geringes spezifisches Gewicht aufweist und trotzdem einen mechanischen Schutz erzeugbar macht sowie eine Wärme ableitende Funktion hat.

Weitere Vorteile ergeben sich aus den Unteransprüchen.

### Die Erfindung wird nun näher erläutert:

Ein Elektrogerät, insbesondere ein Umrichter, weist Wärme erzeugende Bauelemente auf, deren Wärme an die Umgebungsluft über einen Schaumstoff abgeführt werden.

Die Wärme erzeugenden Bauelemente sind auf einer Leiterplatte bestückt und dort lötverbunden.

Der Schaumstoff umgibt die Bauelemente samt Leiterplatte ganz oder zumindest einseitig.

Der Schaumstoff ist elektrisch isolierend ausgeführt und trotzdem wärmeleitend.

Zur Herstellung des Schaumstoffes wird als Basismaterial ein Kunststoff, wie Polypropylen, verwendet und mit Zusätzen, wie beispielsweise auch Farbstoff, versehen. Außerdem werden Bornitrid-Partikel zugesetzt.

Die Bornitrid-Partikel werden als Pulver zugesetzt.

Vor dem Aufschäumen beträgt der Volumen-Anteil der Bornitrid-Partikel zwischen 3 und 30%. Schon bei einem Anteil von 3 bis 5 % ergibt sich nach dem Aufschäumen ein Schaumstoff, der eine hohe Wärmeleitfähigkeit aufweist und trotzdem elektrisch isolierend ist.

Unter hoher Wärmeleitfähigkeit wird eine spezifische Wärmeleitfähigkeit verstanden, die im Vergleich zu handelsüblichem Styropor hundertmal oder gar tausendmal besser ist.

Die Konzentration der Bornitrid-Partikel ist derart gewählt, dass sich von einem Oberflächenabschnitt, welcher der Leiterplatte und/oder den Wärme erzeugenden Bauelementen zugewandt ist, zu einem anderen Oberflächenabschnitt, welcher der Umgebungsluft oder einem Kühlkörper zugewandt ist, eine berührende oder zumindest jeweils fast berührende Kette von Bornitrid-Partikeln ergibt. Innerhalb des Basis-Materials entstehen also Aneinanderreihungen der Bornitrid-Partikel die von der Wärmequelle bis zur Wärmesenke führen. Auf diese Weise wird die Wärme über die Aneinanderreihung der sich berührenden Partikel geleitet.

Da nach dem Aufschäumen der Schaumstoff einen hohen Anteil von Gaseinschlüssen aufweist, welche jeweils von dünnen Wandbereichen umgeben sind, sind die Aneinanderreihungen nur in diesen Wandbereichen wirksam. Denn die Gaseinschlüsse stellen sozusagen Wärmesperren dar. Die Aneinanderreihungen haben von der Wärmequelle bis zur Wärmesenke eine Kettenlänge, die viel größer ist als der direkte Entfernungsabstand .

Die Korngröße der Bornitrid-Partikel ist vorzugsweise kleiner als die durchschnittliche Zellwandstärke zwischen den Gaseinschlüssen, insbesondere kleiner als ein Fünftel der durchschnittlichen Zellwandstärke.

Bei einem weiteren erfindungsgemäßen Ausführungsbeispiel ist der Schaumstoff zwischen den Wärme erzeugenden Bauelementen und einem metallischen Kühlkörper vorgesehen, so dass der Kühlkörper als Wärmesenke fungiert und die Wärme weiterleitet an ein Umgebungsmedium oder an ein Kühlmedium.

Bei einem weiteren erfindungsgemäßen Ausführungsbeispiel ist statt des Zusatzes von Bornitrid auch ein Zusatz eines anderen nichtoxidischen keramischen Stoffes, wie Siliciumcarbid oder Borcarbid, verwendbar. Es sind aber auch Mischungen solcher nichtoxidischen keramischen Stoffe verwendbar. In jedem Fall entsprechen aber Korngröße der Mischung oder des verwendeten Zusatzes und Volumenanteil des gesamten Zusatzes den in den vorgenannten Ausführungsbeispielen genannten Werten.

## Patentansprüche

1. Kühlanordnung für ein Wärme erzeugendes Bauelement,
wobei die Kühlanordnung
- eine Wärmequelle,
- eine Wärmesenke, welche als metallischer Kühlkörper ausgeführt ist,
- und ein zwischen Wärmequelle und Wärmesenke angeordnetes Zwischenteil umfasst,
wobei die Wärmequelle ein Wärme erzeugendes Bauelement ist, welches auf einer Leiterplatte bestückt ist,
wobei das Zwischenteil aus wärmeleitendem Schaumstoff gefertigt ist, und wobei das Zwischenteil die Wärmequelle mit der Wärmesenke verbindet,
wobei der Schaumstoff Gaseinschlüsse und/oder Gas-befüllte Ausnehmungen aufweist, welche jeweils zumindest teilweise oder ganz von einem Basis-Material des Schaumstoffs umgeben sind,
wobei das Basis-Material des Schaumstoffs ein Kunststoff, insbesondere Polypropylen, ist, dem Bornitrid-Pulver als Zusatzstoff beigefügt ist,
wobei das Bornitrid eine durchschnittliche Korngröße zwischen 0,5 µm und 50 µm, insbesondere zwischen 1µm und 10µm, aufweist,
wobei der Schaumstoff elektrisch isolierend ist, wobei die Isolationsfestigkeit des Schaumstoffes gleich ist wie bei trockener Luft unter Normaldruck bei 20°Celsius oder höher,
wobei der Volumenanteil des Zusatzstoffs im Basis-Material des Schaumstoffs zwischen 3 % und 30 %, insbesondere vorzugsweise 5 bis 15 %, beträgt bezogen auf das Rohmaterial des Schaumstoffs vor dem Aufschäumen des Schaumstoffs,
**dadurch gekennzeichnet, dass** innerhalb des Basis-Material des Schaumstoffs Aneinanderreihungen von sich berührenden Bornitrid-Partikeln, die von der Wärmequelle bis zur Wärmesenke führen, vorhanden sind,
wobei das Zwischenteil die bestückte Leiterplatte beidseitig umgibt und
der Schaumstoff die mit den Wärme erzeugenden Bauelementen bestückte Leiterplatte gehäusebildend umgibt,
wobei dem Basis-Material des Schaumstoffs ein den Flammschutz verbessernder Zusatzstoff beigemischt ist,
wobei der Wärmeleitwiderstand von der Wärmequelle zur Wärmesenke über den Schaumstoff geringer ist als der Wärmeleitwiderstand über jeden anderen Wärmeleitpfad von der Wärmequelle zur Wärmesenke der nicht den Schaumstoff durchläuft.

2. Kühlanordnung nach Anspruch 1,
**dadurch gekennzeichnet, dass**
das Gas Luft oder Kohlendioxid ist.

3. Kühlanordnung nach mindestens einem der vorangegangenen Ansprüche,
**dadurch gekennzeichnet, dass**
dem Basis-Material ein Farbstoff und/oder ein die Kriechstromfestigkeit verbessernder Zusatzstoff beigemischt ist.

## Claims

1. A cooling arrangement for a heat-generating component,
wherein the cooling arrangement comprises
- a heat source,
- a heat sink, which is embodied as a metallic cooling body,
- and an intermediate part arranged between the heat source and heat sink,
wherein the heat source is a heat-generating component which is inserted on a printed circuit board,
wherein the intermediate part is manufactured from thermally conductive foam, and wherein the intermediate part connects the heat source to the heat sink,
wherein the foam has gas inclusions and/or gas-filled recesses, which are surrounded in each case at least partially or entirely by a base material of the foam,
wherein the base material of the foam is a plastics material, in particular polypropylene, to which boron nitride powder is admixed as an additive,
wherein the boron nitride has an average grain size of between 0.5 µm and 50 µm, in particular between 1 µm and 10 µm,
wherein the foam is electrically insulating, the insulation resistance of the foam being the same as in dry air under normal pressure at 20° Celsius or higher,
wherein
the volume percent of the additive in the base material of the foam is between 3% and 30%,
in particular preferably 5 to 15%, relative to the raw material of the foam prior to the foaming of the foam,
**characterised in that** lines of touching boron nitride particles which lead from the heat source to the heat sink, are present within the base material of the foam,
the intermediate part surrounding the populated printed circuit board on either side and
the foam surrounding the printed circuit board populated with the heat-generating components in a housing-forming manner,
an additive which improves the flameproofing being admixed to the base material of the foam,
the thermal resistance from the heat source to the heat sink by way of the foam is less than the thermal resistance by way of any other heat-conduction path from the heat source to the heat sink which does not pass through the foam.

2. A cooling arrangement according to claim 1,
**characterised in that**
the gas is air or carbon dioxide.

3. A cooling arrangement according to at least one of the preceding claims,
**characterised in that**
a dye and/or an additive which improves the tracking resistance is admixed to the base material.

## Revendications

1. Ensemble de refroidissement destiné à un composant engendrant de la chaleur,
ledit ensemble de refroidissement incluant
- une source de chaleur,
- un dissipateur thermique réalisé sous la forme d'un corps refroidisseur métallique,
- et une pièce intermédiaire interposée entre ladite source de chaleur et ledit dissipateur thermique,
la source de chaleur étant un composant engendrant de la chaleur, implanté sur une plaquette à circuits imprimés,
sachant que la pièce intermédiaire est fabriquée en une mousse thermiquement conductrice, et que ladite pièce intermédiaire relie la source de chaleur au dissipateur thermique,
la mousse comportant des inclusions gazeuses et/ou des évidements emplis de gaz qui sont entouré(e)s à chaque fois, au moins en partie ou en totalité, par un matériau de base de ladite mousse,
lequel matériau de base de la mousse est une matière plastique, en particulier du polypropylène auquel de la poudre de nitrure de bore est ajoutée en tant qu'adjuvant,
le nitrure de bore présentant une granulométrie moyenne comprise entre 0,5 µm et 50 µm, notamment entre 1 µm et 10 µm,
la mousse étant électriquement isolante, la rigidité diélectrique de ladite mousse étant la même qu'en présence d'air sec sous une pression normale, à 20° Celsius ou plus,
sachant que
la part volumique de l'adjuvant, dans le matériau de base de la mousse, mesure entre 3 % et 30 %, de préférence, en particulier, de 5 à 15 % rapportée au matériau brut de la mousse préalablement au moussage de ladite mousse,
**caractérisé par** la présence, à l'intérieur du matériau de base de la mousse, d'enchaînements de particules de nitrure de bore mutuellement en contact, qui s'étendent depuis la source de chaleur jusqu'au dissipateur thermique,
sachant que la pièce intermédiaire entoure de part et d'autre la plaquette à circuits imprimés garnie, et que
la mousse entoure, avec formation d'un boîtier, ladite plaquette à circuits imprimés garnie des composants engendrant de la chaleur,
un adjuvant, améliorant l'ignifugation, étant ajouté au matériau de base de la mousse, sachant que la résistivité thermique transitant par la mousse, de la source de chaleur au dissipateur thermique, est moindre que la résistivité thermique empruntant, de ladite source de chaleur audit dissipateur thermique, tout autre trajet de conduction thermique qui ne parcourt pas ladite mousse.

2. Ensemble de refroidissement selon la revendication 1,
**caractérisé par le fait que**
le gaz est de l'air ou du dioxyde de carbone.

3. Ensemble de refroidissement selon au moins l'une des revendications précédentes,
**caractérisé par le fait**
**qu'**un colorant, et/ou un adjuvant améliorant la résistance aux courants de fuite, est (sont) ajouté(s) au matériau de base.
